# EUROPEAN PATENT APPLICATION

(11) **EP 0 867 937 A2**
(43) Date of publication of application: **30.09.1998**
(21) Application number: 98830149.5
(22) Date of filing: 17.03.1998
(51) Int. Cl.: H01L 23/367

(54) **Sectional modular lamellar heat dissipator for electronic circuits**

(30) Priority: 26.03.1997 IT AN970022
(71) Applicant: Pada Engineering - S.r.l., 61030 Saltara (PS) (IT)
(72) Inventor: Franchini, Fabio, Fano (PS) (IT)
(74) Representative: Baldi, Claudio

(57) **Abstract**

This invention concerns a lamellar sectional modular heat dissipator realised by the assembly of the required number of segments provided with special enlarged longitudinal edges used to join the segments in order to realise a continuous surface - on the side of the dissipator - and on which the electronic components to cool, are mounted.

## Description

This patent application concerns a lamellar sectional modular heat dissipator for cooling electronic circuits.

It is common knowledge that the components used in electronic circuits generate heat during operation and that these high temperatures may compromise the efficiency of these components.

For this reason these electronic circuits are generally mounted on heat dissipators which help dissipate the heat generated by the same.

Current dissipators generally consist of an aluminium plate having a face with a closely fitting series of segments and a perfectly smooth opposing face on which the components of the electronic circuit are mounted.

It is evident that the heat produced by these electronic components on the smooth surface of a plate of this kind is disposed of through the fins provided on the opposite face of the plate.

To date these dissipators have been realised using two different techniques; in a single block version realised by extrusion or in an alternative version whereby the supporting plate and the radiant segments are realised separately and then assembled. It should be noted however that both these dissipator models have significant problems.

The single block extruded dissipators for example have a insufficient segment density in that it is not possible to realise closely fitting segments on the supporting plate of these dissipators with current extrusion techniques.

The reduced density of these segments in fact limits the radiant capacity of these dissipators extruded in forced air; only by increasing the density of the segments to a maximum would it be possible to optimise the capacity of dissipators of this kind to dissipate the heat produced by the electronic components, in forced ventilation conditions.

It was for the above reasons that the alternative technology mentioned above was introduced; according to this technology, the supporting plate and the segments of a dissipator are realised separately and then assembled in a successive stage.

In this case, a metal plate is used having a face provided with a series of closely fitting grooves in which skilled labourers fit and house the radiant segments; although this technology ensures a dissipator with a high radiant capacity thanks to the closely fitting series of segments, it is just as evident that this technology is extremely costly and difficult to implement considering the need for skilled labour.

Both the above technologies have another problem related to the fact that to date the plates of dissipators have always been realised in standardised dimensions even if in different sizes. Consequently, when mounting a dissipator in an electronic device, it may not be possible to mount a specific model in that it does not fit into the space available in the device making it necessary to use a smaller model which at times may be too small with respect to the space in the electronic device.

In this case it is obvious that the radiant capacity will be inferior to that obtainable with a dissipator whose dimensions exploit all the space available.

The sectional modular dissipator according to this invention was designed to resolve the limitations of the anterior state of the art. The dissipator in question introduces a totally innovative structural philosophy with respect to the past.

While to date standard dissipators consist inevitably of a supporting plate and a series of segments (regardless of whether the segments are extruded with the part or assembled successively), the new dissipator according to the invention is obtained from a special and innovative segment which is assembled with other identical segments, to form an extremely compact radiant unit as well as the smooth and continuous surface on which the electronic circuit components are mounted. The main feature of the segments used for the realisation of the dissipator according to the invention is that the same are provided with one or both enlarged longitudinal edges having an almost rectangular transverse cross-section, in other words, said segment features two special strips on the transverse edges.

Substantially each of these enlarged edges is provided with its exterior side face - namely that opposite the inner face, joined to the actual segment itself, which is completely flat; the front and rear faces of said enlarged edges are provided with male and female attachment means, which allow each be easily and securely joined to the corresponding enlarged adjacent segments.

It is evident that the front face of the enlarged edge of one of these segments can be joined securely to the rear face of the identical edge of the previous segment, and so on.

In this respect, it is also interesting to note that the assembly of the segments is extremely simple - as will emerge from the description - and does not request special procedures or sophisticated tooling.

After assembly, the adjacent segments are closely fitted so as to form an extremely compact "radiant unit" characterised by a large density of segments and ensuring excellent radiant capacity.

Moreover, the exterior faces of all the enlarged edges of these segments are placed consecutively without interruption thus producing a perfectly smooth surface which is ideal for mounting the components of the electronic circuit whose heat dissipation is required.

The advantages of this technology are quite evident and consist specifically of the possibility of realising dissipators with enormous radiant capacity at fairly low production costs, especially in view of the very simple assembly of the segments.

Attention is also drawn to the fact that by using the segments according to the invention, it is possible to realise dissipators of any length, according to the space available in the electronic device in question; it will be sufficient to assemble the number of segments required according to the housing available.

For major clarity the description according to the invention continues with reference to the enclosed drawing intended for purposes of illustration and not in a limiting sense, whereby:
- figure 1 shows the special profile of one of the segments used to realise the dissipator according to the invention;
- figure 2 shows the dissipator according to the invention using three of the above segments;
- figure 3 is similar to figure 1 but shows an embodiment of the segment provided with only one enlarged longitudinal edge;
- figure 4 is similar to figure 1 but refers to an alternative embodiment of the segment.

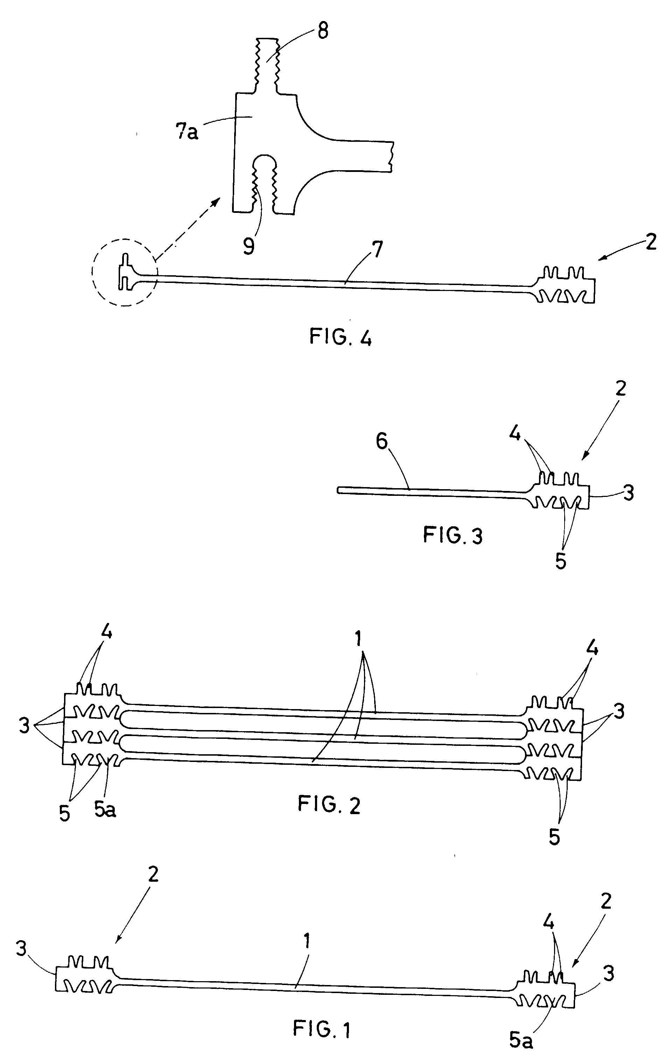

With reference to figure 1, the sectional modular dissipator according to the invention uses a special segment (1) as base-module characterised by specially structured enlarged longitudinal edges (2).

Each of these enlarged edges (2) is provided with a perfectly flat external side face (3); the front face (2a) is provided for its entire length with a double pair of thin elastically opening parallel fins (4) while its posterior face (2b) is provided for its entire length with a double pair of "V" shaped grooves (5).

It being provided with particular reference to figure 2 that each pair of fins (4) on the front face (2a) of the enlarged edge (2) of a segment (1 ) press fits into the corresponding pair of grooves (5) realised on the posterior face (2b) of the enlarged edge (2) of the previous segment.

The two pairs of grooves (5) are opened wide, while, at rest, the pairs of fins (4) are almost parallel; it should however be noted that said fins (4) when housed in their corresponding grooves (5) undergo progressive widening as a result of the interference of the wedge shaped profile (5a) placed between the grooves (5) of each pair.

Substantially, the interference of the wedge (5a) with the fins (4) is such that when the two segments touch, the fins (4) of the posterior segment open to the point of housing the same in the grooves (5).

Evidently, the forcing of the fins (4) of a posterior segment into the corresponding grooves (5) of the previous segments ensures a secure housing remaining almost immobile in position with the fins opened out (4) thus preventing the same from accidentally escaping from the grooves (5).

In order to uncouple the two coupled segments, it will be sufficient to pull the same apart in order to remove the fins (4) of the posterior segment from the corresponding grooves (5) of the previous segment.

It is evident that when the wedge (5a) is removed from between each pair of finds (4) the same will elastically resume their practically parallel position at rest, as shown in figure 1.

With reference to figure 2, it is evident that the external side faces (3) of all the joined segments (1) form an aligned and perfectly consecutive arrangement, thus forming a smooth and continuous surface on which to fit the electronic circuit components; the dissipator shown in figure 2 is provided with two different surfaces on which the electronic components to cool may be mounted; the first surface formed by the series of enlarged edges (2) on the right of the segments (1) and the second surface formed by the series of enlarged edges (2) on the left of the segments (1).

Figure 3 shows an alternative embodiment of the above segments whereby the segment (6) differentiates from the model in figure 1 in that the same features the enlarged edge (2) only along one of its longitudinal sides.

The dissipator provided with such segments (6) will obviously have only one surface on which to mount the electronic components with respect to which the radiant segments (6) are staggered.

Figure 4 shows a further embodiment of segment (7) also provided with one enlarged edge (2) which is however longer than that illustrated in figure 3.

This particular segment (7) is provided with a second and different shaped edge (7a) again along the longitudinal side opposite to the side having the enlarged edge (2), fins (4) and grooves (5); this second shaped edge (7a) is provided at the front with a male-profile (8) and at the back with a conforming female-profile (9), both being provided with saw-tooth edges.

It is evident that the male-profile (8) of a posterior segment will press fit and remain housed in the female-profile (9) of the previous segments, thanks also to the saw-toothed edges.

In particular, the coupling of these two profiles (8 and 9) occurs when the fins (4) of the posterior segment are housed into the corresponding grooves (5) of the previous segment.

The presence of the second shaped edge (7a) on segment (7) has two precise technical reasons.

The first is to make the structure of the dissipator consisting of a number of these special segments (7) more stable; considering in fact the length of the same, it is evident that their coupling would be insecure and the entire structure of the dissipator rather unstable - if they were connected only along the enlarged longitudinal edge (2) provided with fins (4) and grooves (5).

The second reason is to realise ducts, closed on both sides, between each of the fins (7) and to those adjacent to the same; said ducts in fact ensure more efficient heat dissipation.

It is evident moreover that in the case of a dissipator realised with the type of segments (7) as shown in figure 4, the electronic components can be mounted only on the unbroken surface consisting of the exterior side faces (3) of the enlarged edge (2) provided with fins (4) and grooves (5).

## Claims

1. A sectional modular lamellar heat dissipator for electronic components characterised in that the same is realised by assembly of numerous segments (1 or 6 or 7) provided with one or two enlarged longitudinal edges (2), each having a perfectly flat external side face (3), a front face (2a) provided for its entire length with a double pair of thin parallel fins (4) which open elastically and a rear face (2b) provided for its entire length with a double pair of "V" shaped grooves (5) separated by a wedge shaped profile (5a) and designed to house by press-fitting, the fins (4) on the front face (2a) of the enlarged edge (2a) of an identical previous segment.

2. A sectional modular lamellar heat dissipator for electronic circuits according to claim 1, characterised in consisting of numerous identical segments (1) each provided with the above enlarged edges (2) along both its longitudinal sides.

3. A sectional modular lamellar heat dissipator for electronic circuits according to claim 1, characterised in consisting of numerous identical segments (6) each provided with a single enlarged edge (2) along one of its longitudinal sides.

4. A sectional modular lamellar heat dissipator for electronic circuits, according to claim 1, characterised in consisting of numerous identical segments (6) each provided with an enlarged edge (2) on one of its longitudinal sides and by a second special enlarged edge (7a) on the other longitudinal side; it being provided that said edge (7a) features a front male-profile (8) and a rear female-profile (9), both having saw-toothed edges.
